# EUROPÄISCHE PATENTSCHRIFT

(11) **EP 1 762 128 B1**
(45) Veröffentlichungstag und Bekanntmachung des Hinweises auf die Patenterteilung: **10.08.2016**
(21) Anmeldenummer: 05756833.9
(22) Anmeldetag: 21.06.2005
(51) Int. Cl.: H05K 3/00

(54) **VERFAHREN ZUR HERSTELLUNG VON DURCHKONTAKTIERUNGEN AUFWEISENDEN LEITERPLATTENGEBILDEN**
METHOD FOR PRODUCING PRINTED CIRCUIT BOARD STRUCTURES COMPRISING VIA HOLES
PROCEDE DE PRODUCTION DE STRUCTURES DE CARTES DE CIRCUITS PRESENTANT DES TROUS DE PASSAGE

(30) Priorität: 30.06.2004 DE 102004031729; 30.06.2004 DE 102004031718; 30.06.2004 DE 102004031730
(43) Veröffentlichungstag der Anmeldung: 14.03.2007
(73) Patentinhaber: Gigaset Communications GmbH, 40549 Düsseldorf (DE)
(72) Erfinder: BUSCH, Georg, 48683 Ahaus (DE)
(74) Vertreter: Michalski Hüttermann & Partner Patentanwälte mbB
(86) Internationale Anmeldenummer: PCT/EP2005/052881
(87) Internationale Veröffentlichungsnummer: WO 2006/003097

(56) Entgegenhaltungen:
- JP-A- H09 191 168
- US-A- 3 562 009
- US-A1- 2002 000 370
- US-A1- 2004 069 864
- US-B1- 7 276 385
- ANONYMOUS: "Removal of Polyimide Laser Etch Debris by Wet Etching" IBM TECHNICAL DISCLOSURE BULLETIN, Bd. 36, Nr. 2, 1. Februar 1993 (1993-02-01), XP002350794 New York, US
- "COMBINED LASER PROCESSING OF VIAS AND CIRCUITRY IN FLEX-CIRCUITS" IBM TECHNICAL DISCLOSURE BULLETIN, IBM CORP. NEW YORK, US, Bd. 38, Nr. 5, 1. Mai 1995 (1995-05-01), Seiten 607-608, XP000519699 ISSN: 0018-8689
- PATENT ABSTRACTS OF JAPAN Bd. 004, Nr. 071 (E-012), 24. Mai 1980 (1980-05-24) -& JP 55 038051 A (FUJITSU LTD), 17. März 1980 (1980-03-17)
- PATENT ABSTRACTS OF JAPAN Bd. 1997, Nr. 11, 28. November 1997 (1997-11-28) -& JP 09 191168 A (YAMAMOTO SEISAKUSHO:KK), 22. Juli 1997 (1997-07-22)

## Beschreibung

Die Erfindung betrifft ein Verfahren zur Herstellung von Durchkontaktierungen aufweisenden Leiterplattengebilden gemäß dem Oberbegriff des Anspruchs 1.

Bei Verfahren für die Herstellung von zwei- oder mehrlagigen Leiterplattengebilden stellen Durchkontaktierungen im Allgemeinen und insbesondere Mikro-Durchkontaktierungen auf kleinstem Raum mit einem Pad-Durchmesser kleiner 200 µm ein Problem dar. Nach derzeitigem Technologiestand können beispielsweise Mikro-vias mit einem Lochdurchmesser von 75 bis 100 µm und einem Pad-Durchmesser von 250 bis 300 µm gefertigt werden.

Entsprechende Angaben gehen aus den Unterlagen beispielsweise der Firma P.C.M. GmbH, Hattsteiner Allee 17, 61250 Usingen, URL: http://www.p-m-c.de/Produkte/Standardleiterplatten/tech-rdllp_d.htm hervor.

Außerdem ist zur Herstellung von Schaltungsträgern mit, verschlossenen Durchkontaktierungen und geringen Schichtdicken allgemein bekannt, in eine beidseitig Kupfer beschichtete Folie die Durchkontaktierungslöcher einzubringen und zu bekeimen. Anschließend wird Kupfer aufgebracht, das eventuell galvanisch noch verstärkt wird. Nach dem Aufbringen einer photoempfindlichen Schicht wird das Leiterbild mittels Dia aufgebracht. Ein Lack dient als Ätzschutz für das Leiterbild. In weiteren Prozessschritten wird das Leiterbild geätzt und der Ätzschutz wieder entfernt.

Damit sind die Herstellungskosten solcher Leiterplattengebilden relativ teuer.

Daneben ist aus dem Dokument WO 2004/015161 A1 ein Verfahren und eine Anordnung zur Bearbeitung von Trägermaterial durch Schwerionenbestrahlung und nachfolgendem Ätzprozess bekannt, die dazu verwendet werden, die Oberfläche eines Trägermittels eines Leiterplattengebildes bzw. des Trägermaterials des Leiterplattengebildes aufzurauen, damit eine nachfolgend aufzubringende Kupferschicht auf der entsprechend bearbeiteten Oberfläche des Trägermittels bzw. des Trägermaterials sicher dort hält.

Das Aufrauen der Oberfläche ist insbesondere dann wichtig, wenn die Kupferschicht kleberlos auf das Trägermittel bzw. Trägermaterial aufgebracht wird und wenn es sich bei dem Trägermittel bzw. Trägermaterial um Kunststoff wie zum Beispiel Polyimid handelt.

Polyimid (PI) wird für hochwertige Leiterplattengebilden verwendet, die biegbar, das heißt flexibel sind. Andere Beispiele für solche Trägermittel sind Polyethylennaphtalat (PEN) oder Polyester (PET). Für starre Leiterplattengebilden kann als Trägermittel beispielsweise CEM1, FR2 oder FR4 eingesetzt werden.

Bei bisherigen Herstellungsprozessen für die Herstellung von Leiterplattengebilden werden zum Zeitpunkt der Realisierung der Durchkontaktierungen Trägermittel verwendet, die schon kupferbeschichtet sind. Dies hat zur Folge, dass beim Herstellen der elektrischen Durchkontaktierung zumindest an einigen Stellen eine weitere Kupferschichtlage aufgebracht wird, durch die die Dicke der Leiterbahnen des letztlich erhaltenen Leiterplattengebildes erhöht wird. Außerdem ist damit der Aufwand für das Aufbringen der ersten Kupferschichtlage redundant erfolgt, da sie durch die zweite Kupferschichtlage ersetzt werden kann.

Ein weiterer Nachteil ist, dass die insgesamt erhaltene dickere Kupferschicht nur eine gröbere Leiterbahnstruktur als eine dünnere Gesamtkupferschicht zulässt. Im Übrigen soll versucht werden, eine weitere Reduzierung des Platzbedarfs für die Durchkontaktierungen zu erreichen, damit beispielsweise mehr als bisher auf einer vorgegebenen Fläche des Leiterplattengebildes untergebracht werden können.

Bekannt sind auch Geräteeinheiten mit flexibler Leiterbahnenfolie, auf der innerhalb der durch die darauf angeordneten Leiterbahnen gebildete Leitungsstruktur Anschlusspunkte ausgebildet sind, an denen Verbindungen zwischen einzelnen Leiterbahnen der Leitungsstruktur oder zwischen Leiterbahnen der Leitungsstruktur und elektronischen Schaltkreisen oder sonstigen elektronischen Funktionskomponenten hergestellt sind. Beispiele für solche Geräteeinheiten sind flexible Displays und kabellose oder mobile Telefongeräte, die entweder solche flexiblen Displays mit flexibler Leiterbahnenfolie oder darüber hinaus flexible Leiterbahnenfolien haben. Daneben geht heute die Entwicklung zu immer kleineren und/oder komplexer funktionierenden Geräteeinheiten hin.

Das zuletzt Genannte hat zur Folge, dass die inneren Strukturen solcher Geräteeinheiten immer feiner und kleiner werden. Dies trifft in besonderem Maß auf die Leitungsstruktur von Leiterbahnenfolien zu, wobei innerhalb der besagten Leitungsstruktur Stellen ausgebildet sind, an denen Verbindungen zwischen einzelnen Leiterbahnen der Leitungsstruktur oder Verbindungen zu elektronischen Schaltkreisen oder sonstigen elektronischen Funktionskomponenten realisiert sind. Die besagten Stellen können dazu beispielsweise als Durchkontaktierungen oder ausschließliche Anschlusspunkt ausgebildet sein. Es ist aber auch eine Kombination der beiden genannten Maßnahmen für ausgewählte Stellen möglich. Dabei wird oft auf allerkleinstem Raum eine maximal hohe Anzahl an solchen verbindenden Stellen benötigt.

Durchkontaktierungen basieren auf in die Leiterbahnenfolie eingebrachten Durchgangskanälen. Anschlusspunkte basieren auf kleinen Anschlussflächen vorgegebener Größe, die auch als Pads bezeichnet werden. Die gewählten Durchmesser der Durchgangskanäle bzw. deren mit ihnen zusammenhängenden Anschlusspunkte bzw. der Anschlusspunkte an sich bestimmen die maximale Anzahl von innerhalb einer vorgegebenen Flächeneinheit
anordenbaren Durchkontaktierungen bzw. Anschlusspunkte. Da mit zunehmender Miniaturisierung der Geräteeinheiten aber auch mit zunehmender Komplexität der innerhalb der Geräteeinheiten benötigten Schaltungen der Bedarf an einer hohen Anzahl an innerhalb solcher Flächeneinheiten anordenbaren Anschlusspunkte bzw. Durchkontaktierungen steigt, sind kleine Durchmesser für die Durchkontaktierungen bzw. die Pads wichtig.

Derzeit können technische Löcher bzw. Durchgangskanäle mit Durchmessern im Bereich von 20 nm und größer hergestellt werden. Erreicht werden kann dies mit Methoden, bei denen ein Schwerionenbeschuss oder ein Feinstlasern durchgeführt wird. Diese dabei erhaltenen Löcher bzw. jeweiligen Mengen an Löchern an jeweiligen gewünschten Stellen können mittels eines nachgeschalteten Ätzschrittes jeweils auf Löcher vorgegebener Größe erweitert werden. Eine mögliche Größe für die gewählte Erweiterung kann beispielsweise bei 1 bis 5 µm liegen. Sie kann aber auch kleiner oder größer gewählt sein. Die genannte Größe stellt schon eine sehr kleine Größe dar. In vielen Fällen können die Löcher bzw. Durchgänge beispielsweise auf 20 bis 40 µm erweitert und mit Pads in der Größenordnung von 75 bis 150 µm kombiniert sein. Damit sind darauf basierende Verbindungsstellen immer noch wesentlich kleiner als solche, die mit herkömmlichen Methoden hergestellt werden. Es lassen sich somit Anschlussstellen in einer Dichte mindestens in der Größenordnung von 150 bis 300 DPI verwirklichen.

Aus dem Dokument DE 198 35 158 A1 ist ein Verfahren zur Erzeugung von Leiterplatten bekannt, bei dem an Stellen, an denen eine Durchkontaktierung vorzusehen ist, mit einem entsprechenden Lochherstellungsverfahren höchstens ein einziges Loch eingebracht wird. Die vorgeschlagenen Lochherstellungsverfahren sind ein Laserbohren und, an Stelle des Laserbohrens, ein mechanisches Bohren. Das Laser- und das mechanische Bohren sind hier nebeneinander gestellt. Die Lochergebnisse beider Verfahren sind daher ebenfalls nebeneinander zu sehen. Da die Lochergebnisse mechanischen Bohrens gröber sind, sind die Lochergebnisse des Laserbohrens so zu sehen, dass auch sie gröber sind. Von einem Feinstlasern jedenfalls ist nicht die Rede, das zumindest die Möglichkeit eröffnet, an Stellen, an denen eine Durchkontaktierung vorzusehen ist, mindestens ein einziges Loch vorzusehen.

Aus dem Dokument US 3 904 783 A ist ein Verfahren zur Herstellung gedruckter Schaltkreise bekannt, dessen entscheidender Punkt die Verwendung eines speziellen Stoffs für die Abdeckung der Oberfläche des gedruckten Schaltkreises in bestimmten Verfahrensstadien ist. Die Schaltkreise beziehen zwar auch Durchkontaktierungen mit ein. Es ist aber insbesondere nichts darüber gesagt, wie und in welcher Ausgestaltung die Bohrungen der Durchkontaktierungen erzeugt sind.

Aus dem Dokument DE 100 58 822 A1 ist ein Verfahren zur Bearbeitung von Trägerfolien durch Bestrahlung mit Schwerionen bekannt, wobei dieses Bestrahlen lediglich als Grundlage dafür dient, im Zusammenhang mit einem nachfolgenden Zeit- und Geschwindigkeit gesteuerten Ätzschritt ein gewünschtes Oberflächen-Tiefen-Relief zu erzeugen, um darauf wiederum mechanisch eine weitere Schicht zu befestigen. Ein Durchschießen der Schwerionen ist definitiv ausgeschlossen. Damit geht dieser Stand der Technik nicht über den eingangs bereits erwähnten Stand der Technik gemäß des Dokuments WO 2004/015161 A1 hinaus.

Aus den Dokumenten DE 33 37 049 C2 und DE 196 50 881 C2 sind Verfahren mit Schwerionenbeschuss unterschiedlicher Materialien bekannt, die auch durchschossen werden. Der Durchschuss betrifft aber nicht die Herstellung von Durchkontaktierungen an sich, sondern die Herstellung allgemein unterschiedlicher Leitfähigkeiten des Materials in senkrecht aufeinanderstehenden Richtungen. Dabei sollen in Nachbarschaft liegende Durchschüsse grundsätzlich einzelne Durchschüsse bleiben.

Aus dem Dokument "Removal of Polyimide Laser Etch Debris by Wet Etching" eines unbekannten Verfassers, IBM TECHNICAL DISCLOSURE BULLETIN, Bd. 36, Nr. 2, 1. Februar 1993 (1993-02.01), Seiten 439-440, New York, US ist ein Verfahren bekannt, bei dem Löcher durch Laserbohren in einem Polyimidsubstrat hergestellt werden. Bei der Herstellung dieser Löcher werden, durch das Laserbohren, an den Wänden der Löcher Rückstände (debris) produziert. Zum Entfernen dieser Rückstände wird nach dem Laserbohren ein Atzprozess durchgeführt mittels KOH Lösung. Es ist aus dem genannten Dokument ferner bekannt, dass ein solcher Ätzprozess nicht nur die Rückstände entfernt sondern auch die Löcher vergrößert werden.

Das Dokument US 3,562,009 A beschreibt ein Verfahren zum Erstellen von Durchgangslöchern in einem Substrat mittels Laserstrahl oder alternativ mittels Elektronenbeschuss.

Das Dokument US 2004/0069864 A1 beschreibt eine bei Brennkraftmaschinen verwendete Einrichtung zum Verdüsen von Kraftstoff, deren Düsenöffnungen mittels Ionenbeschuss hergestellt sind.

Aufgabe der vorliegenden Erfindung ist es somit, ein Verfahren zur Herstellung von Durchkontaktierungen aufweisenden Leiterplattengebilden der eingangs genannten Art anzugeben, das einen vereinfachten Herstellungsprozess hat und damit kostengünstiger ist, das die Herstellung kleinster Durchkontaktierungen ermöglicht, und das auch bei Leiterplattengebilden verwendbar ist, die kleberlos hergestellt werden und flexibel sind.

Die Aufgabe wird erfindungsgemäß durch ein Verfahren gelöst, das die im kennzeichnenden Teil des Anspruchs 1 angegebenen Verfahrensschritte aufweist.

Danach werden zum Zeitpunkt der Herstellung der Durchkontaktierungen Trägermittel verwendet, die noch keine Kupferschicht auf den Oberflächen haben. Damit entfallen bis zu diesem Zeitpunkt bereits solche Herstellungsschritte, die notwendig sind, um diese Schichten auf das Trägermittel zu montieren. Damit wird das Gesamtverfahren zur Herstellung des Leiterplattengebildes letztlich vereinfacht.

Vor dem Montieren irgendwelcher Schichten wird an für Durchkontaktierungen vorgesehenen Stellen des späteren Leiterplattengebildes mit einem Lochherstellungsverfahren, das ein Schwerionenbeschuss ist, zum Herstellen jeweils wenigstens eines einzigen Lochs an einer jeweils betreffenden Stelle wenigstens jeweils ein einziges Loch erzeugt. Das heißt, dass die produzierten Durchkontaktierungen jeweils mindestens aus einem einzigen, in der Regel aber aus vielen kleinsten Durchgangsbohrungen gebildet sind.

Unter Umständen kann neben dem Schwerionenbeschuss auch Feinstlasern und/oder die Technik des Laserns oder des Bohrens eingesetzt werden. Der Schwerionenbeschuss bzw. das Feinstlasern hat insbesondere den vorteil, dass kleinste Durchkontaktierungen realisiert werden können.

Mit Hilfe eines sich anschließenden Ätzprozesses können die fabrizierten Löcher auf ein gewünschtes Maß aufgeätzt werden. Dabei werden, falls zum Beispiel das verwendete Lochherstellungsverfahren es mit sich bringt, dass an einer vorgesehenen Stelle gleichzeitig mehr als ein einziges Loch innerhalb eines vorgegebenen Umfelds nebeneinander erzeugt wird, wie das beispielsweise beim Beschuss von Schwerionen möglich ist, gegebenenfalls mehrere nah beieinander liegende Löcher zu einem einzigen größeren Loch gewünschter Größe aufgeweitet. Insgesamt haben aber auch diese Endlöcher dann beispielsweise einen Lochdurchmesser von 1 bis 5 µm, was derzeit das mögliche praktische Kleinstloch für eine Durchkontaktierung darstellt.

Erst im nachfolgenden Verfahrensschritt erfolgt die Kupferkaschierung der Oberflächen des Trägermittels bzw. des Trägermaterials des Leiterplattengebildes. Dabei wird gleichzeitig die elektrische Durchkontaktierung zwischen den Kupferkaschierungen durch die im vorherigen Verfahrensschritt hergestellten Löcher bewerkstelligt. Da dieser Verfahrensschritt in jedem Fall notwendig ist, weil sonst die Durchkontaktierungen elektrisch nicht nutzbar wären, sind Maßnahmen, die vorab ein bereits kupferkaschiertes Trägermittel bereitstellen, redundant. Diese Redundanz wird hier mit dem vorliegenden Verfahren vermieden.

Da bisher noch keine Kupferschichten vorhanden waren sind außerdem die Dicken der Kupferkaschierungen minimal. Es lassen sich somit mit diesen Kupferkaschierungen feinste Leiterbahnstrukturen herstellen.

Außerdem haben die kleinen Durchmesser der Durchkontaktierungen den ganz besonderen Vorteil, dass diese beim Herstellen der elektrischen Durchkontaktierungen vollständig und quasi mit planer Oberfläche mit Kupfer gefüllt werden.

Dies ist vorteilhaft im Hinblick auf das Fließen maximaler Stromdichten über diese Durchkontaktierungen und ist vorteilhaft im Hinblick auf eine Beibehaltung einer planen Oberfläche des Trägermittels ohne zusätzlichen Aufwand an weiteren Arbeitsschritten.

Es müssten ansonsten die Löcher in zusätzlichen Arbeitsschritten vollständig gefüllt und die Enden plan abgeschliffen werden.

lassen sich somit mit diesen Kupferkaschierungen feinste Leiterbahnstrukturen herstellen.

Außerdem haben die kleinen Durchmesser der Durchkontaktierungen den ganz besonderen Vorteil, dass diese beim Herstellen der elektrischen Durchkontaktierungen vollständig und quasi mit planer Oberfläche mit Kupfer gefüllt werden.

Dies ist vorteilhaft im Hinblick auf das Fließen maximaler Stromdichten über diese Durchkontaktierungen und ist vorteilhaft im Hinblick auf eine Beibehaltung einer planen Oberfläche des Trägermittels ohne zusätzlichen Aufwand an weiteren Arbeitsschritten.

Es müssten ansonsten die Löcher in zusätzlichen Arbeitsschritten vollständig gefüllt und die Enden plan abgeschliffen werden.

Beim Verfüllen größerer Löcher, und das wären dann die Durchkontaktierungen, wenn sie nicht mit dem Kupferkaschieren gleich vollständig verfüllt werden könnten, entstehen nämlich an den Enden der Durchkontaktierungen in der Regel hügelige Kappen. Nur wenn die Durchkontaktierungen gefüllt und die Enden plan sind, können die sich darauf befindlichen Flächen zum Beispiel für Leiterbahnen oder in irgendeiner Form für irgendwelche sonstigen Schaltungskonstruktionen genutzt werden. Solche Nutzungen sollen mit den vorliegenden Verfahrensschritten aber möglich gemacht werden. Mit anderen Worten, mit den angegebenen Verfahrensschritten sind mit einem minimalen Aufwand eine insgesamt maximale Flächenausnutzung der Oberfläche des Trägermittels des Leiterplattengebildes und zusätzlich die Verwendung feinster Strukturen in diesem Zusammenhang möglich. Damit ist beispielsweise die Verkleinerung des Leiterplattengebildes und/oder die Erhöhung des Komplexitätsgrads der darauf beziehungsweise damit realisierten Schaltungskonstruktion möglich.

Pads, die aber immer noch insgesamt sehr klein sind, an den Enden miteinander parallel geschaltet werden.

Vorteilhafte Ausgestaltungen der Erfindung sind Gegenstand von entsprechend zugehörigen Unteransprüchen.

Danach wird vor dem Kupferkaschieren auf dem alleinigen Trägermittel, also auf dem Trägermittel ohne jeglichem Kupfer, das heißt ohne jeglicher Kupferkaschierung oder jeglichen Kupferbahnen, das Leiterbild strukturiert und für den nachfolgenden Schritt aktiviert. Danach wird in einem chemischen Verkupferungsprozess auf dem aktivierten Leiterbild Kupfer aufgebracht, wobei gleichzeitig die Durchkontaktierungen durchkontaktiert werden. Das heißt, eine flächige Kupferkaschierung wird eingespart und es wird sofort das Leiterbahnengebilde erzeugt.

Der Vorteil bei der Anwendung dieses Verfahrens ist, dass die Herstellkosten vergleichbar sind mit heutigen Folien, die als Rohmaterial angeliefert werden, beidseitig mit Kupfer beschichtet und ohne Durchkontaktierungen und ohne Leiterbild sind.

Weiter vorteilhaft ist die Möglichkeit der Verwendung von flexiblen Materialien wie Polyimid als Trägermittel, weil damit zum Beispiel flexible Leiterplattengebilden hergestellt werden können. Dies sogar mit kleinsten Durchkontaktierungen und feinsten Leiterbahnstrukturen. Die besagten kleinsten Durchkontaktierungen sind deutlich kleiner als bisher bekannte Durchkontaktierungen. Sie haben wiederum den Vorteil, dass sie sich mit der Bewerkstelligung der elektrischen Durchkontaktierung gleich vollständig verfüllen mit an deren Enden planen Oberflächen. Sie können deshalb in kleinste Anschlüsse von BGR (Ball Grid Array), CSP (Cip Size Packaging) oder Flip-Chips untergebracht werden.

Besteht der Bedarf an einer Kupferverstärkung von Leiterbahnen, wie dies zum Beispiel bei Stromversorgungs-Leiterbahnen der Fall sein kann, kann dieses ohne weiteres mit herkömmlichen Methoden noch bewerkstelligt werden.

Ein anderer Vorteil ist, dass der Verfahrensschritt des Aufrauens der Oberfläche des Trägermittels zur Vorbereitung des Haftgrundes für die Kupferkaschierung nicht vorab erfolgen muss, sondern beim Schwerionenbeschuss des Trägermittels für die Herstellung der Durchgangskanäle für die Durchkontaktierungen gleichzeitig mit gemacht werden kann. Dies kann zum Beispiel dadurch geschehen, dass an den vorgesehenen Stellen die Durchgangskanäle fabriziert werden und an den entsprechenden übrigen Stellen durch entsprechende andere Steuerung der Intensität des Schwerionenbeschusses die Oberflächen des Trägermittels nur mehr aufgeraut werden.

Das Aufrauen geschieht dabei dadurch, dass die Schwerionen an den betreffenden Stellen der Oberfläche des Trägermittels wenigstens im Wesentlichen nur mehr oberflächlich in das Trägermittel eindringen.

Mit der Möglichkeit des Aufrauens der Oberflächen des Trägermittels ist der Vorteil verbunden, dass die Kupferkaschierungen des Leiterplattengebildes kleberlos aufgebracht werden können.

Der Aufätzprozess für das Aufätzen der Locher auf eine gewünschte Größe kann in sehr einfacher Weise in Abhängigkeit von der Prozesszeit für das Ätzen gesteuert werden. Dabei kann problemlos gesteuert werden, dass die Lochgrößen der Durchkontaktierungen die Größenordnung von 1 bis 5 µm annehmen. Außerdem können ohne weiteres Durchkontaktierungen mit Hilfe entsprechend großer Pads über den Durchkontaktierungen parallel geschaltet werden.

## Patentansprüche

1. Verfahren zur Herstellung von Durchkontaktierungen aufweisenden Leiterplattengebilden, die aus einem Trägermittel bestehen, auf dem letztlich alle weiteren Mittel angeordnet werden, mit denen im Zusammenwirken mit dem Trägermittel das Leiterplattengebilde realisiert wird, **dadurch gekennzeichnet, dass** das alleinige Trägermittel vor dem Aufbringen aller weiterer Mittel an für Durchkontaktierungen vorgesehenen Stellen des späteren Leiterplattengebildes mit einem Lochherstellungsverfahren zum Herstellen jeweils wenigstens eines einzigen Lochs bearbeitet wird, das ein Schwerionenbeschuss ist, dass nachfolgend ein Ätzprozess durchgeführt wird, mit dem an den besagten Durchkontaktierungsstellen das jeweilige Loch zu einer gewünschten Größe aufgeätzt wird oder die jeweiligen Löcher zu einem oder mehreren Löchern gewünschter Größe aufgeätzt werden, dass ein Kupferkaschierungsprozess durchgeführt wird, bei dem eine vorhandene Ober- und Unterseite des Trägermittels, auf denen die Anordnung aller weiterer Mittel zur Bildung des Leiterplattengebildes in späteren Schritten vorgenommen wird, kupferkaschiert und dabei gleichzeitig die elektrisch leitenden Durchkontaktierungen durch die im vorherigen Verfahrensschritt erzeugten Löcher fabriziert werden, und dass anschließend alle weiteren Schritte zur Anordnung aller weiterer Mittel zur Realisierung des vollständigen Leiterplattengebildes realisiert werden.

2. Verfahren nach Anspruch 1, **dadurch gekennzeichnet, dass** vor dem Kupferkaschierungsprozess auf dem alleinigen Trägermittel das Leiterbild strukturiert und für den nachfolgenden Schritt aktiviert wird, und dass beim anschließenden Kupferkaschierungsprozess in einem chemischen Verkupferungsprozesses auf dem aktivierten Leiterbild Kupfer aufgebracht wird und dabei gleichzeitig die Durchkontaktierungen durchkontaktiert werden.

3. Verfahren nach Anspruch 1 oder 2, **dadurch gekennzeichnet, dass** als Trägermittel eine Polyimidfolie verwendet wird.

4. Verfahren nach einem der vorherigen Ansprüche, **dadurch gekennzeichnet, dass** beim Schwerionenbeschuss des Trägermittels gleichzeitig ein Aufrauen von Stellen auf der vom Schwerionenbeschuss betroffenen Seite des Trägermittels durchgeführt wird, in dem die Intensität des Schwerionenbeschusses jeweils an den betreffenden Steillen jeweils so verändert wird, dass die Schwerionen wenigstens im wesentlichen nur mehr an der Oberfläche des Trägermittels in das Trägermittel eindringen und die Oberfläche dabei aufrauen bzw. aufraut.

5. Verfahren nach einem der vorherigen Ansprüche, **dadurch gekennzeichnet, dass** das Leiterplattengebilde als kleberloses Leiterplattengebilde realisiert wird.

6. Verfahren nach einem der vorherigen Ansprüche, **dadurch gekennzeichnet, dass** der Aufätzprozess für das Aufätzen der Löcher auf eine gewünschte Größe in Abhängigkeit einer Prozesszeit für das Ätzen gesteuert wird.

7. Verfahren nach einem der vorherigen Ansprüche, **dadurch gekennzeichnet, dass** bei einem entsprechenden Bedarf mehrere Durchkontaktierungen mit Hilfe entsprechend groß ausgebildeter Pads auf der Ober- und Unterseite des Trägermittels ober- und unterhalb der Durchkontaktierungen elektrisch parallel geschaltet werden.

8. Verfahren nach einem der vorherigen Ansprüche, **dadurch gekennzeichnet, dass** das Aufätzen der Löcher in der Weise durchgeführt wird, dass Lochgrößen in der Größenordnung von 1 bis 5 µm erhalten werden.

## Claims

1. A method for the manufacture of circuit board structures comprising through-connections, which consist of a carrier means, on which ultimately all further means are arranged with which the circuit board structure is realised in conjunction with the carrier means, **characterised in that** the single carrier means prior to attaching any further means, is treated, at positions of the later circuit board structure envisaged for through-connections, with a hole-forming process for producing at least one single hole respectively, which is a heavy-ion bombardment, **in that** subsequently an etching process is performed, with which the respective hole is enlarged at the said through-connection positions to obtain the desired size or the respective holes are etched to obtain one or more holes of the desired size, **in that** a copper-laminating process is performed, where an existing topside and underside of the carrier means, on which all further means for forming the circuit board structure in later steps are arranged, are copper-laminated whilst at the same time fabricating the electrically conducting through-connections through the holes generated in the previous process step, and **in that** subsequently all further steps are realised for arranging all further means for realising the complete circuit board structure.

2. The method according to claim 1, **characterised in that** prior to the copper-laminating process the circuit image is structured on the single carrier means and is activated for the subsequent step, and **in that** during the subsequent copper-laminating process copper is applied to the activated circuit image in a chemical copper-plating process and that the through-connections are through-contacted at the same time.

3. The method according to claim 1 or 2, **characterised in that** a polyimide film is used as carrier means.

4. The method according to one of the preceding claims, **characterised in that** during the heavy-ion bombardment of the carrier means simultaneously a roughening of positions on the side of the carrier means, which is affected by the heavy-ion bombardment, is performed, in which the intensity of the heavy-ion bombardment at the respective positions is altered in such a way that the heavy ions, at least substantially only on the surface of the carrier means, penetrate into the carrier means, roughening the surface in the process thereof.

5. The method according to one of the preceding claims, **characterised in that** the circuit board structure is realised as a circuit board structure without adhesive.

6. The method according to one of the preceding claims, **characterised in that** the etching process for enlarging the holes to obtain a desired size is controlled in dependence of a process time for the etching.

7. The method according to one of the preceding claims, **characterised in that** for an appropriate demand, several through-connections are electrically connected in parallel with the aid of correspondingly large-sized pads on the topside and underside of the carrier means above and below the through-connections.

8. The method according to one of the preceding claims, **characterised in that** etching of the holes is effected in such a way that hole sizes of a magnitude between 1 to 5 µm are obtained.

## Revendications

1. Procédé pour fabriquer des structures de cartes de circuits imprimés comportant des traversées métallisées qui sont constituées d'un moyen de support sur lequel sont placés en finalité tous les autres moyens, à l'aide desquels en coopération avec le moyen de support, la structure de carte de circuits intégrés sera réalisée, **caractérisé en ce qu'**avant d'appliquer tous les autres moyens, on traite le seul moyen de support, sur des endroits prévus pour des contacts de passage traversant de la structure de carte de circuits imprimés ultérieure, avant l'application de tous les autres moyens par un procédé de création de trous pour la fabrication respectivement d'au moins un seule trou qui est un bombardement par ions lourds, **en ce que** par la suite, il est réalisé un processus de gravure, à l'aide duquel, sur lesdits endroits de contacts de passage traversant, le trou respectif est ouvert par gravure à une taille souhaitée ou les trous respectifs sont ouverts par gravure en un ou en plusieurs trous de la taille souhaitée, **en ce qu'**il est procédé à un processus de plaquage de cuivre, lors duquel une face supérieure et inférieure présentes du moyen de support, sur lesquelles le placement de tous les autres moyens pour la création de la structure de carte de circuits imprimés lors d'étapes ultérieures est effectué, sont plaquées avec du cuivre et à cet effet, les contacts de passage traversant conducteurs d'électricité à travers les trous générés lors de l'étape de procédé précédente sont fabriqués simultanément, et **en ce que** par la suite toutes les étapes supplémentaires pour le placement de tous les autres moyens pour la réalisation de la structure complète de carte de circuits imprimés sont réalisées.

2. Procédé selon la revendication 1, **caractérisé en ce qu'**avant le processus de placage au cuivre sur le seul moyen de support, l'image de circuit conducteur est structurée et activée pour l'étape suivante, et **en ce que** lors du processus suivant de placage au cuivre dans le cadre d'un processus de cuivrage chimique, du cuivre est appliqué sur l'image de circuit activée et à cet effet, les contacts de passage traversant sont métallisés simultanément.

3. Procédé selon la revendication 1 ou la revendication 2, **caractérisé en ce qu'**en tant que moyen de support, un film de polyimide est utilisé.

4. Procédé selon l'une quelconque des revendications précédentes, **caractérisé en ce que** lors du bombardement aux ions lourds du moyen de support, il est procédé simultanément à un grainage d'endroits sur la face concernée par du bombardement aux ions lourds avant le bombardement aux ions lourds du moyen de support, **en ce que** l'intensité du bombardement aux ions lourds sur les endroits concernés est changée respectivement de telle sorte que les ions lourds pénètrent au moins sensiblement plus dans le moyen de support uniquement sur la surface du moyen de support et grainent la surface à cet effet.

5. Procédé selon l'une quelconque des revendications précédentes, **caractérisé en ce qu'**on réalise la structure de carte à circuits imprimés en tant que structure de carte à circuits imprimés exempte d'agents adhésifs.

6. Procédé selon l'une quelconque des revendications précédentes, **caractérisé en ce que** le procédé d'ouverture par gravure destiné à ouvrir par gravure les trous à une taille souhaitée est commandé en fonction d'un temps de processus pour la gravure.

7. Procédé selon l'une quelconque des revendications précédentes, **caractérisé en ce que** dans le cas d'un besoin correspondant, plusieurs contacts de passage traversant sont connectés électriquement en parallèle à l'aide de plots conçus dans une taille correspondante sur la face supérieure et inférieure du moyen de support, au-dessus et en dessous des contacts de passage traversant.

8. Procédé selon l'une quelconque des revendications précédentes, **caractérisé en ce que** l'ouverture par gravure de trous est effectuée de sorte que des tailles de trous dans l'ordre de grandeur de 1 à 5 µm sont obtenues.
